# DEMANDE DE BREVET EUROPEEN

(11) **EP 1 289 025 A1**
(43) Date de publication de la demande: **05.03.2003**
(21) Numéro de dépôt: 01810840.7
(22) Date de dépôt: 30.08.2001
(51) Int. Cl.: H01L 31/18, H01L 31/075

(54) **Procédé de dépot d'une couche d'oxyde sur un substrat et cellule photovoltaique utilisant ce substrat**

(71) Demandeur: UNIVERSITE DE NEUCHATEL, 2000 Neuchatel (CH)
(72) Inventeur: Kroll, Ulrich, 2035 Corcelles (CH); Meier, Johannes, 2035 Corcelles (CH)
(74) Mandataire: Gresset, Jean

(57) **Abrégé**

Le procédé selon l'invention permet de déposer une couche d'oxyde conducteur transparent (12) sur un substrat en verre trempé (10) disposé à l'intérieur d'une enceinte (26). Il consiste:
- à se doter de sources (32, 34 36) contenant respectivement un composé sous forme liquide du métal destiné à former l'oxyde, de l'eau et un dopant sous forme gazeuse,
- à établir dans l'enceinte une température comprise entre 130 et 300°C et une pression comprise entre 0.01 et 2 mbar, puis
- à mettre lesdites sources en communication avec l'enceinte, ce qui a pour effet de vaporiser les deux liquides à leur surface et de les faire réagir avec le dopant dans l'enceinte de manière à ce que la couche d'oxyde soit formée sur le substrat.

## Description

La présente invention concerne un procédé de dépôt d'une couche d'oxyde transparent sur un substrat, qui s'applique particulièrement bien à la fabrication d'une cellule photovoltaïque, également désignée cellule solaire. L'invention concerne aussi une telle cellule dont la couche d'oxyde transparent est déposée selon ce procédé.

Les cellules solaires les plus avancées technologiquement, à ce jour, comportent un substrat, une couche d'oxyde conducteur transparent TCO (Transparent Conductive Oxyde) déposée sur le substrat et une couche photovoltaïquement active déposée sur la couche d'oxyde. Cette couche photosensible est avantageusement composée de trois sous-couches de silicium hydrogéné amorphe, microcristallin ou nanocristallin formant une jonction p-i-n. Plus précisément, les deux sous-couches externes sont respectivement dopées positivement et négativement, tandis que la sous-couche intermédiaire est intrinsèque.

Une cellule de ce type est décrite en détail, par exemple, selon plusieurs formes de réalisation, dans la demande EP 96934294.8.

Dans l'état actuel de la technique, les cellules photovoltaïques utilisent généralement une couche d'oxyde conducteur transparent réalisée en dioxyde d'étain (SnO₂) ou oxyde de zinc (ZnO) déposée sur un substrat en verre par le procédé de vaporisation chimique connu sous l'abréviation CVD (Chemical Vapor Deposition), qui s'effectue à une température généralement comprise entre 400 et 550 °C.

Or, il est particulièrement intéressant de pouvoir déposer la couche d'oxyde à une température inférieure car cela permettrait d'utiliser un substrat, tel que le verre trempé, qui répond aux normes de sécurité exigées pour une application à l'extérieur.

Malheureusement, les températures mentionnées ci-dessus ont pour effet d'altérer les propriétés du substrat qui lui ont été conférées par le trempage.

A ce jour, on doit donc se contenter de cellules solaires sur verre non trempé, qui sont relativement fragiles et représentent un danger potentiel important car elles se brisent en morceaux coupants. Leur utilisation sur des immeubles se trouve ainsi limitée, voire prohibée pour l'équipement de façades.

Le brevet US 4 623 601 décrit un procédé de dépôt en phase vapeur, dans lequel les composés chimiques participant à la réaction sont amenés à la chambre par un gaz porteur saturé en ces composés par barbotage.

Une telle méthode permet d'utiliser des conditions de réactions douces, mais pas de bien contrôler la quantité de réactifs mise en jeu, car l'équilibre thermodynamique qui régit le seuil de saturation du gaz porteur dépend fortement de la température et du flux de ce gaz. Comme il est problématique de fixer précisément la température dans l'ensemble du circuit, on risque donc d'avoir une recondensation non contrôlée de réactifs en un endroit plus froid de l'installation.

La présente invention a pour but de fournir un procédé de dépôt permettant non seulement l'utilisation d'un substrat en verre trempé ou tout autre matériau résistant mal à des températures élevées ( supérieures à 300° C) mais également un contrôle précis de la quantité de réactifs engagés, car les conditions expérimentales régnant dans le circuit d'alimentation sont suffisantes pour éviter toute recondensation intempestive.

De façon plus précise, l'invention concerne un procédé de dépôt d'une couche d'oxyde conducteur transparent sur un substrat disposé à l'intérieur d'une enceinte, caractérisé en ce qu'il consiste :
- à se doter de sources contenant respectivement un composé sous forme liquide du métal destiné à former l'oxyde, de l'eau et un dopant sous forme gazeuse,
- à établir dans l'enceinte une température comprise entre 130 et 300°C et une pression comprise entre 0.01 et 2 mbar, puis
- à mettre lesdites sources en communication avec l'enceinte, ce qui a pour effet de vaporiser les deux liquides à leur surface et de les faire réagir avec le dopant dans l'enceinte de manière à ce que la couche d'oxyde soit formée sur le substrat.

Selon l'invention, lorsque les températures mentionnées ci-dessus sont trop basses pour permettre les réactions chimiques conduisant à la formation de l'oxyde, la vaporisation chimique s'effectue dans un plasma des gaz de dépôt, formé à l'intérieur de l'enceinte, de préférence en utilisant la technique du PECVD (Plasma Enhanced Chemical Vapor Deposition), bien connue de l'homme de métier.

L'invention concerne également une cellule photovoltaïque caractérisée en ce qu'elle comporte:
- un substrat,
- une couche d'oxyde conducteur transparent déposée sur le substrat par le procédé défini précédemment, et
- une couche photovoltaïquement active déposée sur la couche d'oxyde.

De façon avantageuse, la couche active de la cellule comporte trois sous-couches de silicium hydrogéné amorphe, microcristallin ou nanocristallin formant une jonction p-i-n, les deux sous-couches externes étant respectivement dopées positivement et négativement.

Avantageusement, le substrat est en verre, de préférence en verre trempé, mais il peut être aussi en acier inox, en aluminium ou en un polymère.

D'autres caractéristiques de l'invention ressortiront de la description qui va suivre, faite en regard du dessin annexé, dans lequel:
- la figure 1 est une vue en coupe d'une cellule selon l'invention, et
- la figure 2 montre schématiquement un équipement pour la fabrication de cette cellule.

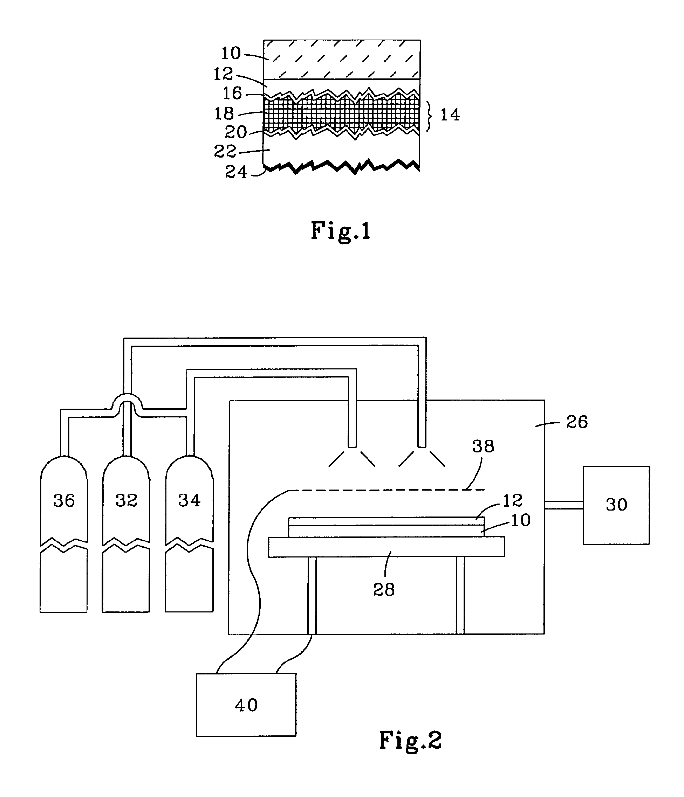

La cellule représentée sur la figure 1 utilise comme substrat 10 une mince plaque de verre trempé, ayant une épaisseur de l'ordre de 1 à 8 mm, sur laquelle est déposée une couche d'oxyde conducteur transparent (TCO) 12 ayant, typiquement, une épaisseur de 0.2 à 4 µm.

La couche 12, avantageusement constituée de dioxyde d'étain (SnO₂) ou d'oxyde de zinc (ZnO), est déposée par vaporisation chimique (CVD) selon un procédé qui sera décrit plus loin.

Une couche photovoltaïquement active 14, ayant une épaisseur d'environ 0.2 à 10 µm, est déposée sur la couche d'oxyde 12. Elle est composée de trois sous-couches de silicium hydrogéné amorphe, microcristallin ou nanocristallin 16, 18 et 20, formant une jonction p-i-n. Les deux sous-couches externes 16 et 20 sont respectivement dopées positivement et négativement.

Finalement, la cellule comporte encore une couche de contact arrière 22, par exemple en oxyde de zinc, déposée sur la couche active 14 et une couche réfléchissante 24, par exemple en argent ou en aluminium, déposée sur la couche 22.

D'autres structures de cellules peuvent être réalisées sur le même substrat en verre trempé et la même couche d'oxyde transparent. Elles sont décrites en détail dans le document EP déjà cité.

On se référera maintenant à la figure 2 qui représente l'équipement permettant le dépôt par CVD d'une couche d'oxyde de zinc 12 sur la plaque de verre trempé 10. Sur cette figure, on a représenté en 26 une enceinte étanche dotée d'un support chauffant 28 sur lequel est déposée la plaque de verre trempé. L'enceinte 26 est raccordée à une pompe à vide 30 ainsi qu'à trois réservoirs 32, 34 et 36 contenant, le premier, de l'eau, le deuxième, du diéthylezinc (C₂H₅)₂Zn et le troisième, un dopant, avantageusement sous la forme de diborane (B₂H₆). Bien entendu, d'autres composés à base de zinc et d'autres dopants, tous bien connus de l'homme de métier, peuvent être utilisés. Les contenus des deux réservoirs 32 et 34 sont liquides, tandis que celui du réservoir 36 est un mélange gazeux de 0.5 à 2 % de diborane dilué dans un gaz inerte. On notera que les réservoirs 32 et 34 sont reliés directement à l'enceinte, alors que le réservoir 36 est préalablement raccordé au conduit d'amené du réservoir 34.

En fonctionnement, l'enceinte 26 est portée, à l'aide du support chauffant 28, à une température d'environ 180°C, mais qui peut être comprise entre 130 et 300 °C, tandis que la pompe 30 abaisse la pression à une valeur de 0.3 à 0.5 mbar, mais qui peut être comprise entre 0.01 et 2 mbar. Les vannes réglables (non représentées) reliant les réservoirs 32, 34 et 36 à l'enceinte 26 sont alors ouvertes. Du fait de la très faible pression établie dans l'enceinte et donc dans les réservoirs, le diéthylzinc et l'eau contenus dans ces derniers à l'état liquide s'évaporent à leur surface et les gaz résultant réagissent entre eux et avec le gaz dopant (B₂H₆) pour provoquer, selon une réaction connue, le dépôt de la couche d'oxyde de zinc désirée 12 sur la plaque de verre trempé 10.

L'opération se déroulant à une température relativement peu élevée, le verre trempé ne subit aucune détérioration de ses propriétés. Par ailleurs, compte tenu de la pression homogène et faible régnant dans l'installation, les gaz vaporisés ne risquent pas de se recondenser avant leur admission dans l'enceinte.

Le procédé ci-dessus convient parfaitement pour le dépôt d'oxyde de zinc dopé au diborane car les réactions chimiques mises en jeu se font sans problème aux températures mentionnées. En revanche, lorsqu'il s'agit d'effectuer un dépôt CVD de dioxyde d'étain ou un dépôt d'oxyde de zinc avec un dopant plus stable tel que le tétrafluorure de méthyle (CF₄), ces températures sont trop basses pour que les réactions aient lieu normalement.

Selon l'invention, le dépôt de la couche d'oxyde est alors réalisé par le procédé de vaporisation chimique sous plasma PECVD. Dans ce cas, l'enceinte 26 est équipée d'une électrode, par exemple en forme de grille 38, disposée au-dessus du support chauffant 28 et un générateur électrique 40 est connecté entre cette électrode et le support.

Ainsi, en fonctionnement, alors que la température et la pression sont maintenues aux valeurs mentionnées précédemment, les gaz introduits dans l'enceinte 26 donnent lieu à la formation d'un plasma entre l'électrode 38 et le support 28. Des radicaux actifs sont ainsi générés et permettent que les réactions chimiques donnant lieu au dépôt de la couche d'oxyde se fassent à une température sensiblement plus basse que celle normalement nécessaire, préservant ainsi les propriétés du substrat.

De façon avantageuse, pour obtenir le dépôt souhaité de SnO_{2,} les réservoirs 34 et 36 contiennent respectivement, par exemple, du tetraméthyleétain (CH₃)₄Sn et, comme dopant, du tétrafluorure de méthyle (CF₄). Il va de soi que d'autres composés, bien connus dans la pratique, peuvent être utilisés.

On notera que l'eau du réservoir 32 peut être avantageusement additionnée de composés contenant de l'oxygène ( N₂O, CH₃OH, C₂H₅OH,...).

La présente description a été faite en se référant à un substrat en verre trempé car il trouve une application particulièrement intéressante pour l'équipement de façades, mais il va de soi que d'autres substrats, tels que le verre normal, l'acier inox, l'aluminium ou des polymères,.... peuvent être utilisés dans le cadre de l'invention.

## Revendications

1. Procédé de dépôt d'une couche d'oxyde conducteur transparent (12) sur un substrat (10) disposé à l'intérieur d'une enceinte (26), **caractérisé en ce qu'**il consiste :
- à se doter de sources (32, 34, 36) contenant respectivement un composé sous forme liquide du métal destiné à former l'oxyde, de l'eau et un dopant sous forme gazeuse,
- à établir dans ladite enceinte une température comprise entre 130 et 300°C et une pression comprise entre 0.01 et 2 mbar, puis
- à mettre lesdites sources en communication avec ladite enceinte, ce qui a pour effet de vaporiser les deux liquides à leur surface et de les faire réagir avec le dopant dans l'enceinte de manière à ce que ladite couche d'oxyde soit formée sur le substrat.

2. Procédé selon la revendication 1, **caractérisé en ce qu'**il consiste, en plus, à former un plasma des liquides vaporisés à l'intérieur de la chambre.

3. Cellule photovoltaïque **caractérisée en ce qu'**elle comporte :
- un substrat (10),
- une couche d'oxyde conducteur transparent (12) déposée sur le substrat en application du procédé selon l'une des revendications 1 et 2, et
- une couche photovoltaïquement active (14) déposée sur la couche d'oxyde.

4. Cellule selon la revendication 3, **caractérisée en ce que** ladite couche active (14) comporte trois sous-couches de silicium hydrogéné amorphe, microcristallin ou nanocristallin formant une jonction p-i-n, les deux sous-couches externes (16 et 20) étant respectivement dopées positivement et négativement.

5. Cellule selon l'une des revendications 3 et 4, **caractérisée en ce que** ledit substrat est du verre.

6. Cellule selon l'une des revendications 3 et 4, **caractérisée en ce que** ledit substrat est du verre trempé.
